# EUROPEAN PATENT APPLICATION

(11) **EP 4 770 354 A1**
(43) Date of publication of application: **01.07.2026**
(21) Application number: 25200775.2
(22) Date of filing: 08.09.2025
(51) Int. Cl.: H10H 29/03, H10H 29/34, H10H 29/39, H10H 29/37

(54) **SELF-ASSEMBLY SUBSTRATE AND DISPLAY DEVICE INCLUDING SELF-ASSEMBLY LINE**

(30) Priority: 27.12.2024 KR 20240198583
(71) Applicant: LG Display Co., Ltd., Seoul, 07336 (KR)
(72) Inventor: KIM, Kang-Hyun, 10845 Paju-si, Gyeonggi-do (KR)
(74) Representative: Viering, Jentschura & Partner mbB Patent- und Rechtsanwälte

(57) **Abstract**

A self-assembly substrate and a display device including a self-assembly line. The self-assembly substrate includes a first assembly line (134) and a second assembly line (136) spaced apart from each other in a first direction (X) and extending in a second direction; an insulation layer (117) on the first and second assembly lines (134, 136), the insulation layer (117) having an assembly hole (117h) between the first and second assembly lines (134, 136); a first assembly electrode (135) between the first assembly line (134) and the assembly hole (117h); and a second assembly electrode (137) between the second assembly line (136) and the assembly hole (117h), wherein the first and second assembly electrodes (135, 137) respectively include a first side (S1) exposed by the assembly hole (117h) and a second side (S2) connected to the first and second assembly lines (134, 136), and wherein each end of the first side (S1) is located within the assembly hole (117h) and spaced apart from an edge of the assembly hole (117h).

## Description

### BACKGROUND

### Technical Field

The present disclosure relates to a display device, and more particularly, to a self-assembly substrate and a display device including a self-assembly line.

### Discussion of the Related Art

As the information society progresses, a demand for different types of display devices increases, and flat panel display devices (FPD) such as liquid crystal display devices and light-emitting diode display devices have been developed and applied to various fields.

Among the flat panel display devices, light-emitting diode display devices emit light due to the radiative recombination of an exciton. The exciton is formed from an electron and a hole by injecting charges into a light-emitting layer between a cathode for injecting electrons and an anode for injecting holes in a light-emitting diode.

The light-emitting diode display device can offer various advantages and improved properties. For instance, compared to the liquid crystal display device, because it is self-luminous, the light-emitting diode display device has a wide viewing angle, and since a backlight unit is not required, the light-emitting diode display device has an ultra-thin thickness and light weight. In addition, the light-emitting diode display device is also advantageous in power consumption.

The light-emitting diode display device may include inorganic-based light-emitting elements and organic-based light-emitting elements. The inorganic-based light-emitting elements have relatively excellent stability, fast response characteristics, and high contrast ratios, and micro light-emitting diodes (micro LEDs or µLEDs) are widely used as the inorganic-based light-emitting elements for high resolution.

The inorganic-based light-emitting elements may be formed on a separate substrate and transferred to an array substrate of a display device. During the transfer process, the light-emitting elements may be assembled in duplicate or may be damaged, resulting in the transfer defects.

### SUMMARY

Accordingly, embodiments of the present disclosure are directed to a self-assembly substrate and a display device that substantially obviate one or more of the problems due to limitations and disadvantages of the related art.

An aspect of the present disclosure is to provide a self-assembly substrate and a display device including a self-assembly line and capable of preventing a transfer defect of a light-emitting element.

Additional features and aspects will be set forth in the description that follows, and in part will be apparent from the description, or can be learned by practice of the inventive concepts provided herein. Other features and aspects of the inventive concepts can be realized and attained by the structure particularly pointed out in the written description, or derivable therefrom, and the claims hereof as well as the appended drawings.

To achieve these and other aspects of the inventive concepts, as embodied and broadly described herein, there is provided a self-assembly substrate according to claim 1. Preferred embodiments are described in the dependent claims. In an aspect, a self-assembly substrate includes a first assembly line and a second assembly line spaced apart from each other in a first direction and extending in a second direction crossing the first direction; an insulation layer on the first assembly line and the second assembly line, the insulation layer having an assembly hole between the first assembly line and the second assembly line; a first assembly electrode between the first assembly line and the assembly hole; and a second assembly electrode between the second assembly line and the assembly hole, wherein the first and second assembly electrodes respectively include a first side exposed by the assembly hole and a second side connected to the first and second assembly lines, and wherein each end of the first side is located within the assembly hole and spaced apart from an edge of the assembly hole.

In another aspect, a display device includes a substrate; a first assembly line and a second assembly line on the substrate, the first and second assembly lines spaced apart from each other in a first direction and extending in a second direction crossing the first direction; a first assembly electrode and a second assembly electrode between the first assembly line and the second assembly line and spaced apart from each other in the first direction; and a light-emitting element self-assembled on the first assembly electrode and the second assembly electrode, wherein the first and second assembly electrodes respectively include a first side covered by the light-emitting element and a second side connected the first and second assembly lines, and wherein the first side is located within a boundary of the light-emitting element.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the disclosure and which are incorporated in and constitute a part of this application, illustrate embodiments of the disclosure and together with the description serve to explain various principles of the disclosure. In the drawings:
FIG. 1 is a schematic plan view of a self-assembly substrate of a light-emitting element according to an embodiment of the present disclosure;
FIG. 2 is a schematic cross-sectional view corresponding to line A-A' of FIG. 1;
FIG. 3 is a schematic plan view of a self-assembly substrate of a light-emitting element of another example according to an embodiment of the present disclosure;
FIG. 4 is a schematic plan view of a self-assembly substrate of a light-emitting element of another example according to an embodiment of the present disclosure;
FIG. 5 is a schematic plan view of a display device according to an embodiment of the present disclosure;
FIG. 6 is a schematic cross-sectional view of a display device according to an embodiment of the present disclosure corresponding to line I-I' of FIG. 5;
FIG. 7 is a schematic plan view of a display device according to another embodiment of the present disclosure;
FIG. 8 is a schematic cross-sectional view of a display device according to another embodiment of the present disclosure corresponding to line II-II' of FIG. 7;
FIG. 9 is a schematic cross-sectional view of a display device according to another embodiment of the present disclosure corresponding to line III-III' of FIG. 7; and
FIG. 10 is a schematic cross-sectional view of a display device according to another embodiment of the present disclosure corresponding to line IV-IV' of FIG. 7.

### DETAILED DESCRIPTION

Advantages and features of the present disclosure and methods for achieving them will be made clear from embodiments described in detail below with reference to the accompanying drawings. The present disclosure can, however, be implemented in many different forms and should not be construed as being limited to the embodiments set forth herein, and the embodiments are provided such that this disclosure will be thorough and complete and will fully convey the scope of the present disclosure to those skilled in the art to which the present disclosure pertains.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

The same reference numerals refer to the same components throughout this disclosure.

Further, in the following description of the present disclosure, when a detailed description of a known related art is determined to unnecessarily obscure the gist of the present disclosure, the detailed description thereof will be omitted herein or may be briefly discussed.

When terms such as "including," "having," "comprising" and the like mentioned in this disclosure are used, other parts can be added unless the term "only" is used herein.

Further, when a component is expressed as being singular, being plural is included unless otherwise specified.

In analyzing a component, an error range is interpreted as being included even when there is no explicit description.

In describing a positional relationship, for example, when a positional relationship of two parts/layers is described as being "over," "on," "above," "below," "under," "next to," or the like, one or more other parts/layers can be provided between the two parts/layers, unless the term "immediately" or "directly" is used therewith.

In describing a temporal relationship, for example, when a temporal predecessor relationship is described as being "after," "subsequent," "next to," "prior to," or the like, unless "immediately" or "directly" is used, cases that are not continuous or sequential can also be included.

As used herein, the terms "connected" and "coupled" are intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner. For example, the term "in contact with," as used herein, encompasses both "indirect contact" and "direct contact." Accordingly, when the phrase "A is in contact with B" is used, it implies that other components may be present between A and B, unless explicitly specified as "A is in direct contact with B."

Although the terms first, second, and the like are used to describe various components, these components are not substantially limited by these terms. These terms are used only to distinguish one component from another component, and may not define any order or sequence. Therefore, a first component described below can substantially be a second component within the technical spirit of the present disclosure.

Features of various embodiments of the present disclosure can be partially or entirely united or combined with each other, technically various interlocking and driving are possible, and each of the embodiments can be independently implemented with respect to each other or implemented together in a related relationship.

Hereinafter, exemplary embodiments of the present disclosure will be described in detail with reference to accompanying drawings.

A display device according to an embodiment of the present disclosure may include a plurality of sub-pixels, and each sub-pixel may include a light-emitting element. The light-emitting element may be formed on a separate growth substrate, self-assembled onto an assembly substrate, and then transferred from the assembly substrate onto a substrate of the display device, i.e., a substrate provided with a thin film transistor, using a donor.

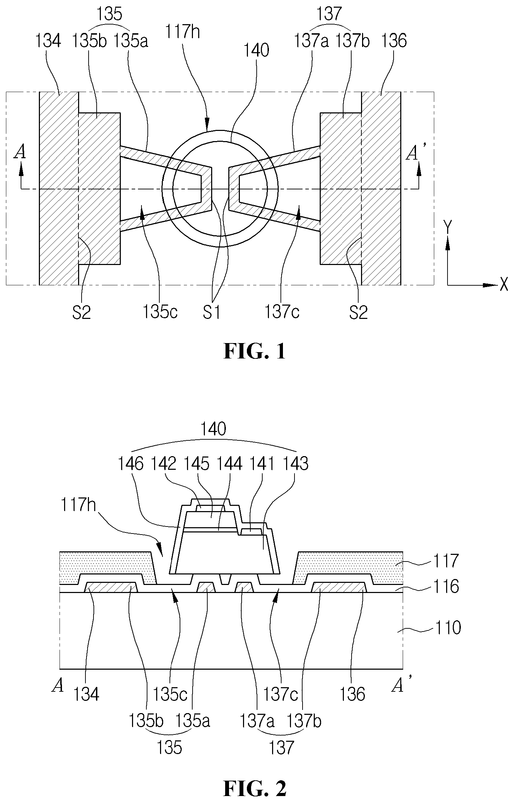

A structure of an assembly electrode of a light-emitting element according to an embodiment of the present disclosure for preventing transfer defects of the light-emitting element during the transfer process will be described with reference to FIG. 1.

FIG. 1 is a schematic plan view of a self-assembly substrate of a light-emitting element according to an embodiment of the present disclosure. FIG. 2 is a schematic cross-sectional view of a self-assembly substrate of a light-emitting element according to an embodiment of the present disclosure and shows a cross-section corresponding to line A-A' of FIG. 1.

In FIG. 1 and FIG. 2, the self-assembly substrate of a light-emitting element according to the embodiment of the present disclosure may include first and second assembly lines 134 and 136, first and second assembly electrodes 135 and 137, and an assembly hole 117h on a substrate 110.

The self-assembly substrate may be disposed over a chamber provided with a fluid in which a plurality of light-emitting elements 140 are dispersed, an electric field may be generated between the first and second assembly electrodes 135 and 137 when an AC voltage may be applied to the first and second assembly electrodes 135 and 137, and the light-emitting element 140 may be self-assembled in the assembly hole 117h by a dielectric phoretic force caused by the generated electric field.

Specifically, the first and second assembly lines 134 and 136 and the first and second assembly electrodes 135 and 137 may be provided on the substrate 110.

The first and second assembly lines 134 and 136 may be spaced apart from each other in a first direction X and may extend in a second direction Y crossing the first direction X.

The first and second assembly electrodes 135 and 137 may be disposed between the first and second assembly lines 134 and 136. The first and second assembly electrodes 135 and 137 may be connected to the first and second assembly lines 134 and 136, respectively. The first and second assembly electrodes 135 and 137 may be spaced apart from each other in the first direction X.

The first and second assembly electrodes 135 and 137 may have substantially symmetrical identical shapes and may be symmetrical in the first direction X. The symmetry may be mirror-image symmetry or point symmetry with respect to the center of the assembly hole 117h. Each of the first and second assembly electrodes 135 and 137 may include a first side S1 and a second side S2 extending in the second direction Y and facing each other in the first direction X.

The first side S1 may overlap the light-emitting element 140, and the second side S2 may be spaced apart from the light-emitting element 140. The second side S2 may be adjacent to a corresponding one of the first and second assembly lines 134 and 136 and may be in contact with the corresponding one of the first and second assembly lines 134 and 136.

The first side S1 and the second side S2 may have different lengths, and the length of the first side S1 may be smaller than the length of the second side S2.

The length of the first side S1 may be smaller than diameters of the light-emitting element 140 and the assembly hole 117h. The first side S1 may be disposed within a boundary of the light-emitting element 140 and may not be exposed outside the boundary of the light-emitting element 140. In addition, both ends of the first side S1 of the first and second assembly electrodes 135 and 137 may overlap the light-emitting element 140, may be disposed in the boundary of the light-emitting element 140, and may not be exposed outside the boundary of the light-emitting element 140.

On the other hand, the length of the second side S2 may be greater than the diameters of the light-emitting element 140 and the assembly hole 117h. However, embodiments of the present disclosure are not limited thereto, and the length of the second side S2 may vary.

Each of the first and second assembly electrodes 135 and 137 may include a first electrode portion 135a and 137a and a second electrode portion 135b and 137b.

The first electrode portion 135a and 137a may have the first side S1, and the second electrode portion 135b and 137b may have the second side S2. The first electrode portion 135a and 137a may have a wider width from the first side S1 to the second side S2, more specifically, from the first side S1 to the second electrode portion 135b and 137b. That is, the width of the first electrode portion 135a and 137a may increase from the first side S1 to the second electrode portion 135b and 137b.

For example, the first electrode portion 135a and 137a may have a trapezoidal shape, and the second electrode portion 135b and 137b may have a rectangular shape. However, embodiments of the present disclosure are not limited thereto, and the shapes of the first electrode portion 135a and 137a and the second electrode portion 135b and 137b may vary. In other embodiments, the second electrode portion 135b and 137b may be omitted.

Meanwhile, the first electrode portion 135a and 137a may have an opening 135c and 137c overlapping the light-emitting element 140. Accordingly, the overlapping area between the first electrode portion 135a and 137a of the first and second assembly electrodes 135 and 137 and the light-emitting element 140 may be minimized.

A shape of the opening 135c and 137c may be the same as the shape of the first electrode portion 135a and 137a. For example, the opening 135c and 137c may have a trapezoidal shape.

A first assembly insulation layer 116 may be provided on the first and second assembly lines 134 and 136 and the first and second assembly electrodes 135 and 137. The first assembly insulation layer 116 may be in contact with the substrate 110 through the opening 135c and 137c. The first assembly insulation layer 116 may be formed of an inorganic insulating material.

A second assembly insulation layer 117 may be provided on the first assembly insulation layer 116. The second assembly insulation layer 117 may have the assembly hole 117h. The assembly hole 117h may be provided to overlap the first and second assembly electrodes 135 and 137, and the light-emitting element 140 may be provided in the assembly hole 117h through the self-assembly process. In this case, the assembly hole 117h may overlap the first electrode portion 135a and 137a of the first and second assembly electrodes 135 and 137 and may be spaced apart from the second electrode portion 135b and 137b of the first and second assembly electrodes 135 and 137.

A part of the first electrode portion 135a and 137a of the first and second assembly electrodes 135 and 137 may be exposed through the assembly hole 117h, and a remaining part of the first electrode portion 135a and 137a of the first and second assembly electrodes 135 and 137, the second electrode portion 135b and 137b, and the first and second assembly lines 134 and 136 may be covered with the second assembly insulation layer 117.

Here, the light-emitting element 140 may include first and second element electrodes 141 and 142, a first semiconductor layer 143, a light-emitting layer 144, a second semiconductor layer 145, and a protection layer 146. In this case, the protection layer 146 may cover and may not expose the first and second element electrodes 141 and 142.

The assembly hole 117h may have the same shape as the light-emitting element 140. For example, the assembly hole 117h and the light-emitting element 140 may have a circular, oval or polygonal shape. However, embodiments of the present disclosure are not limited thereto, and the shape of the assembly hole 117h and the light-emitting element 140 may vary.

Considering the assembly margin, an area of the assembly hole 117h may be greater than an area of the light-emitting element 140. Accordingly, the first side S1 of the first electrode portion 135a and 137a may be disposed within the assembly hole 117h and may be spaced apart from an edge of the assembly hole 117h. A distance between an end of the first side S1 and the edge of the assembly hole 117h may be greater than a distance between an edge of a light-emitting element 140 and the edge of the assembly hole 117h. In addition, the first electrode portion 135a and 137a of the first and second assembly electrodes 135 and 137 may be exposed between the assembly hole 117h and the light-emitting element 140.

A distance between the exposed first electrode portions 135a and 137a of the first and second assembly electrodes 135 and 137 may be equal to or greater than a distance between the first sides S1 of the first and second assembly electrodes 135 and 137, which is the shortest distance between the first and second assembly electrodes 135 and 137.

Here, the intensity of the electric field is inversely proportional to the distance between the electrodes. Before self-assembly of the light-emitting element 140, the first sides S1 of the exposed first and second assembly electrodes 135 and 137 may be substantially located at the center of the assembly hole 117h. Therefore, when self-assembling the light-emitting element 140, the intensity of the electric field between the first and second assembly electrodes 135 and 137 may be greatest at the center of the assembly hole 117h.

On the other hand, after self-assembly of the light-emitting element 140, the first sides S1 of the first and second assembly electrodes 135 and 137 may overlap and be covered with the light-emitting element 140, and the distance between the first and second assembly electrodes 135 and 137 that are exposed and not covered by the light-emitting element 140 may be greater than the distance between the first sides S1 of the first and second assembly electrodes 135 and 137. Accordingly, the intensity of the electric field between the first and second assembly electrodes 135 and 137 after self-assembly of the light-emitting element 140 may be less than the intensity of the electric field between the first and second assembly electrodes 135 and 137 during self-assembly of the light-emitting element 140.

As such, in the embodiment of the present disclosure, the length of the first sides S1 of the first and second assembly electrodes 135 and 137 facing each other and overlapping the light-emitting element 140 may be equal to or smaller than the diameter of the light-emitting element 140. The first sides S1 and the corners corresponding to the both ends of each first side S1 may be located within the boundary of the light-emitting element 140 and may not be exposed outside the boundary of the light-emitting element 140.

In the first and second assembly electrodes 135 and 137, the intensity of the electric field may be greatest at the center of the assembly hole 117h during self-assembly of the light-emitting element 140. Accordingly, the light-emitting element 140 may be self-assembled at the center of the assembly hole 117h.

In addition, the intensity of the electric field between the first and second assembly electrodes 135 and 137 after self-assembly of the light-emitting element 140 may be smaller than the intensity of the electric field between the first and second assembly electrodes 135 and 137 before self-assembly of the light-emitting element 140. Therefore, after self-assembly of the light-emitting element 140 within the assembly hole 117h, a defect in which another light-emitting element is assembled in duplicate within the assembly hole 117h can be prevented.

Further, by providing the opening 135c and 137c, a contact area between the first electrode portion 135a and 137a of the first and second assembly electrodes 135 and 137 and the light-emitting element 140 can be minimized, thereby preventing a defect in which the light-emitting element 140 is damaged by Van der Waals forces between the light-emitting element 140 and the assembly substrate during the process of picking up using a donor.

Meanwhile, the first and second assembly lines 134 and 136 and the first and second assembly electrodes 135 and 137 may be used as a power line.

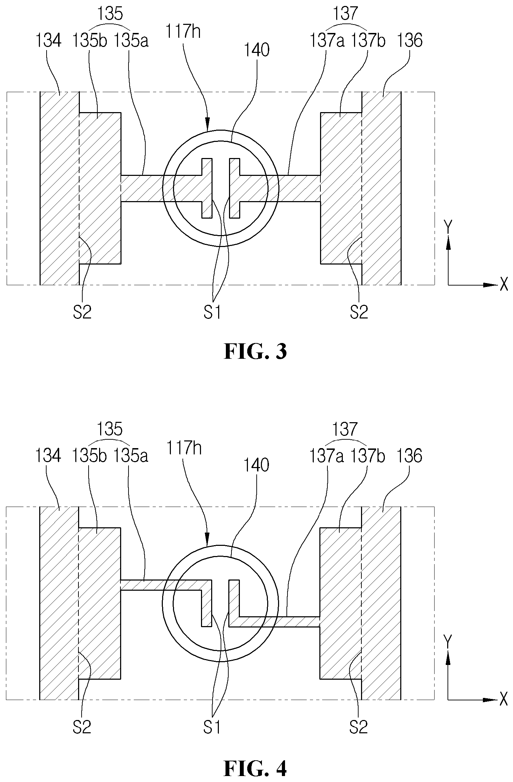

The first and second assembly electrodes 135 and 137 may have various shapes, and this will be described with reference to FIG. 3 and FIG. 4.

FIG. 3 is a schematic plan view of a self-assembly substrate of a light-emitting element of another example according to an embodiment of the present disclosure.

In FIG. 3, the first electrode portion 135a and 137a of the first and second assembly electrodes 135 and 137 may have a T-like shape.

The first electrode portions 135a and 137a may be arranged such that heads or upper parts of the T-like shape face each other. The first electrode portions 135a and 137a of the T-like shape may be symmetrical in the first direction X with respect to the center between the first electrode portions 135a and 137a.

In this case, the head or upper part of the T-like shape may overlap the light-emitting element 140 and may have the first side S1. The head or upper part of the T-like shape may not be exposed to outside the boundary of the light-emitting element 140 and may be located within the boundary of the light-emitting element 140. In the first electrode portions 135a and 137a of the T-like shape, the first side S1 may have a maximum length in the second direction Y.

In addition, the leg or lower part of the T-like shape may be in contact with and electrically connected to the second electrode portion 135b and 137b. If the second electrode portion 135b and 137b is omitted, the leg or lower part of the T-like shape may be in contact with and electrically connected to the corresponding one of the first and second assembly lines 134 and 136.

FIG. 4 is a schematic plan view of a self-assembly substrate of a light-emitting element of another example according to an embodiment of the present disclosure.

In FIG. 4, the first electrode portion 135a and 137a of the first and second assembly electrodes 135 and 137 may have an L-like shape.

The first electrode portions 135a and 137a may be arranged such that lower parts of the L-like shape face each other. The first electrode portions 135a and 137a of the L-like shape may be 180 degrees rotationally symmetric.

In this case, the lower part of the L-like shape may overlap the light-emitting element 140 and may have the first side S1. The lower part of the L-like shape may not be exposed to outside the boundary of the light-emitting element 140 and may be located within the boundary of the light-emitting element 140. In the first electrode portions 135a and 137a of the L-like shape, the first side S1 may have a maximum length in the second direction Y.

In addition, the upper part of the L-like shape may be in contact with and electrically connected to the second electrode portion 135b and 137b. If the second electrode portion 135b and 137b is omitted, the upper part of the L-like shape may be in contact with and electrically connected to the corresponding one of the first and second assembly lines 134 and 136.

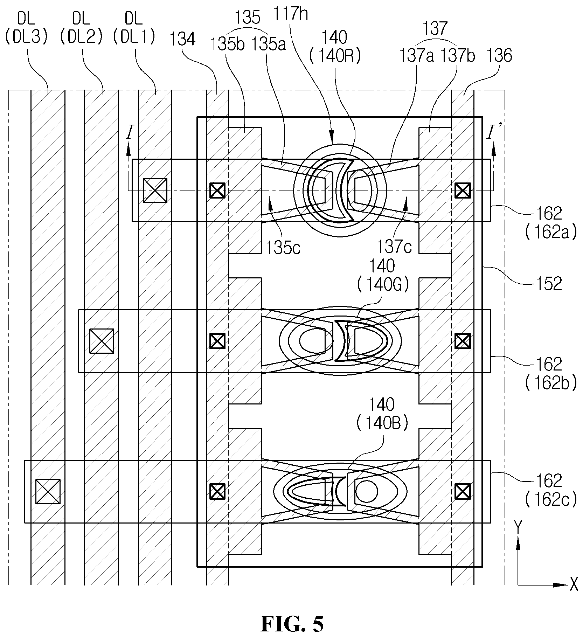

Meanwhile, the first and second assembly electrodes 135 and 137 of the present disclosure may be provided on a substrate of the display device, so that a light-emitting element can be directly transferred onto the substrate of the display device. A planar configuration of such a display device according to an embodiment of the present disclosure will be described with reference to FIG. 5.

FIG. 5 is a schematic plan view of a display device according to an embodiment of the present disclosure, focusing on vertical lines and light-emitting elements.

As shown in FIG. 5, in the display device according to the embodiment of the present disclosure, a plurality of data lines DL, a first assembly line 134, and a second assembly line 136 may be sequentially provided in the first direction X. The plurality of data lines DL, the first assembly line 134, and the second assembly line 136 may be spaced apart from each other in the first direction X and may extend in the second direction Y.

In addition, although not shown in FIG. 5, a plurality of gate lines and a plurality of emission lines may be further provided to extend in the first direction X and to be spaced apart from each other in the second direction Y. The plurality of gate lines and the plurality of emission lines may cross the plurality of data lines DL and the first and second assembly lines 134 and 136 to thereby define a plurality of sub-pixels.

The plurality of data lines DL may include first, second, and third data lines DL1, DL2, and DL3.

A plurality of light-emitting elements 140 may be arranged between the first assembly line 134 and the second assembly line 136. The plurality of light-emitting elements 140 may include red, green, and blue light-emitting elements 140R, 140G, and 140B, which are arranged to be spaced apart from each other in the second direction Y.

The red, green, and blue light-emitting elements 140R, 140G, and 140B may have different shapes or sizes. For example, the red light-emitting element 140R may have a circular shape, and the green and blue light-emitting elements 140G and 140B may have an oval shape with different major and minor axes. In this case, the major axis of the blue light-emitting element 140B may be greater than the major axis of the green light-emitting element 140G, and the minor axis of the blue light-emitting element 140B may be smaller than the minor axis of the green light-emitting element 140G. However, embodiments of the present disclosure, and the shapes of the red, green, and blue light-emitting elements 140R, 140G, and 140B may vary.

The assembly hole 117h may be provided to correspond to each of the red, green, and blue light-emitting elements 140R, 140G, and 140B. The assembly hole 117h may have substantially the same shape as the corresponding one of the red, green, and blue light-emitting elements 140R, 140G, and 140B and may have a larger area than the corresponding one of the red, green, and blue light-emitting elements 140R, 140G, and 140B.

In addition, the first assembly electrode 135 and the second assembly electrode 137 may be provided to correspond to each of the red, green, and blue light-emitting elements 140R, 140G, and 140B. The first assembly electrode 135 and the second assembly electrode 137 may be connected to the first assembly line 134 and the second assembly line 136, respectively.

Each of the first assembly electrode 135 and the second assembly electrode 137 may include the first electrode portion 135a and 137a and the second electrode portion 135b and 137b and have the opening 135c and 137c overlapping the light-emitting element 140. However, embodiments of the present disclosure are not limited thereto. In other embodiments, the second electrode portion 135b and 137b and/or the opening 135c and 137c may be omitted.

The first electrode portion 135a and 137a and the second electrode portion 135b and 137b may have the same configuration as those of FIG. 1. Alternatively, in other embodiments, the first electrode portion 135a and 137a and the second electrode portion 135b and 137b may have the same configuration as those of FIG. 3 or FIG. 4.

Meanwhile, a first pixel electrode 152 may be provided to overlap the red, green, and blue light-emitting elements 140R, 140G, and 140B. In this case, the first pixel electrode 152 may have an open portion partially exposing each of the red, green, and blue light-emitting elements 140R, 140G, and 140B. The first pixel electrode 152 may overlap the first and second assembly lines 134 and 136 and the first and second assembly electrodes 135 and 137.

The first pixel electrode 152 may be electrically connected to the light-emitting element 140 and the first and second assembly lines 134 and 136. The first and second assembly lines 134 and 136 may act as a power line supplying a low potential voltage VSS to the light-emitting element 140.

In addition, a plurality of second pixel electrodes 162 may be provided to overlap the red, green, and blue light-emitting elements 140R, 140G, and 140B, respectively. The plurality of second pixel electrodes 162 may be in contact with and be electrically connected to the partially exposed red, green, and blue light-emitting elements 140R, 140G, and 140B, respectively. The plurality of second pixel electrodes 162 may also be electrically connected to the plurality of data lines DL, respectively.

Specifically, the second pixel electrode 162a overlapping and electrically connected to the red light-emitting element 140R may be electrically connected to a first data line DL1, the second pixel electrode 162b overlapping and electrically connected to the green light-emitting element 140G may be electrically connected to a second data line DL2, and the second pixel electrode 162c overlapping and electrically connected to the blue light-emitting element 140B may be electrically connected to a third data line DL3.

In this case, the plurality of second pixel electrodes 162 may overlap and be in direct contact with the plurality of data lines DL, respectively. Alternatively, the plurality of second pixel electrodes 162 may be electrically connected to the plurality of data lines DL through separate electrodes, respectively.

Meanwhile, the second pixel electrodes 162 may overlap the first and second assembly lines 134 and 136 and the first and second assembly electrodes 135 and 137.

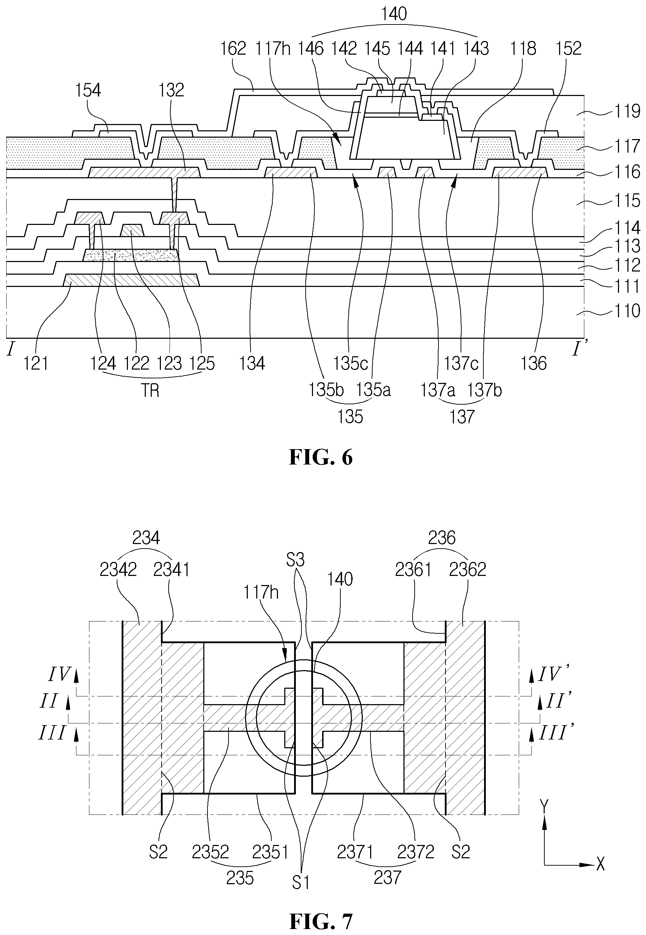

A cross-sectional structure of a display device according to an embodiment of the present disclosure will be described in detail with reference to FIG. 6.

FIG. 6 is a schematic cross-sectional view of a display device according to an embodiment of the present disclosure and shows a cross-section corresponding to line I-I' of FIG. 5.

In FIG. 6, the display device according to the embodiment of the present disclosure may include a thin film transistor TR and a light-emitting element 140 on a substrate 110.

Specifically, a light-shielding layer 121 may be provided on the substrate 110. The substrate 110 can be a glass substrate or a plastic substrate. For example, polyimide can be used for the plastic substrate, and the plastic substrate can have a stacked structure including at least one polyimide layer and at least one inorganic layer. However, embodiments of the present disclosure are not limited thereto.

The light-shielding layer 121 may be formed of a conductive material such as metal. For example, the light-shielding layer 121 may be formed of one or more of: aluminum (Al), copper (Cu), molybdenum (Mo), titanium (Ti), chromium (Cr), nickel (Ni), tungsten (W), and an alloy thereof. The light-shielding layer 121 may have a single-layered structure or a multiple-layered structure.

A buffer layer 111 may be provided on the light-shielding layer 121. The buffer layer 111 may be disposed substantially all over the substrate 110. The buffer layer 111 may be formed as a single layer or multiple layers of an inorganic insulating material. The inorganic insulating material of the buffer layer 111 may include silicon nitride (SiNx), silicon oxide (SiOx), or silicon oxynitride (SiON).

An active layer 122 may be provided on the buffer layer 111. The active layer 122 may overlap the light-shielding layer 121, and the light-shielding layer 121 may block light incident on the active layer 122 and prevent the active layer 122 from deteriorating due to the light.

The active layer 122 may include a channel region at its central part and source and drain regions at both sides of the channel region.

The active layer 122 may be formed of an oxide semiconductor material. Alternatively, the active layer 122 may be formed of polycrystalline silicon, and in this case, both ends of the active layer 122 may be doped with impurities.

A gate insulation layer 112 may be provided on the active layer 122 and the buffer layer 111. The gate insulation layer 112 may be disposed substantially all over the substrate 110. The gate insulation layer 112 may be formed as a single layer or multiple layers of an inorganic insulating material. The inorganic insulating material of the gate insulation layer 112 may include silicon nitride (SiNx), silicon oxide (SiOx), or silicon oxynitride (SiON).

A gate electrode 123 may be formed on the gate insulation layer 112. The gate electrode 123 may overlap the active layer 122 and may be disposed to correspond to the central part of the active layer 122. Accordingly, the gate electrode 123 may also overlap the light-shielding layer 121.

The gate electrode 123 may be formed of a conductive material such as metal. For example, the gate electrode 123 may be formed of one or more of: aluminum (Al), copper (Cu), molybdenum (Mo), titanium (Ti), chromium (Cr), nickel (Ni), tungsten (W), and an alloy thereof. The gate electrode 123 may have a single-layered structure or a multiple-layered structure.

An interlayer insulation layer 113 may be provided on the gate electrode 123. The interlayer insulation layer 113 may be disposed substantially all over the substrate 110. The interlayer insulation layer 113 may be formed as a single layer or multiple layers of an inorganic insulating material. The inorganic insulating material of the interlayer insulation layer 113 may include silicon nitride (SiNx), silicon oxide (SiOx), or silicon oxynitride (SiON).

A source electrode 124 and a drain electrode 125 may be provided on the interlayer insulation layer 113. The source electrode 124 and the drain electrode 125 may be spaced apart from each other with the gate electrode 123 positioned therebetween and may be in contact with both ends of the active layer 122 through contact holes provided in the interlayer insulation layer 113 and the gate insulation layer 112.

The active layer 122, the gate electrode 123, the source electrode 124, and the drain electrode 125 may constitute a thin film transistor TR. The thin film transistor TR may be a driving transistor and may be electrically connected to the data line DL of FIG. 5.

In addition, one or more transistors having substantially the same configuration as the thin film transistor TR may be further provided on the substrate 110. However, embodiments of the present disclosure are not limited thereto.

The source electrode 124 and the drain electrode 125 may be formed of a conductive material such as metal. For example, the source electrode 124 and the drain electrode 125 may be formed of one or more of: aluminum (Al), copper (Cu), molybdenum (Mo), titanium (Ti), chromium (Cr), nickel (Ni), tungsten (W), and an alloy thereof. The source electrode 124 and the drain electrode 125 may have a single-layered structure or a multiple-layered structure.

A passivation layer 114 may be provided on the source electrode 124 and the drain electrode 125. The passivation layer 114 may be disposed substantially all over the substrate 110. The passivation layer 114 may be formed as a single layer or multiple layers of an inorganic insulating material. The inorganic insulating material of the passivation layer 114 may include silicon nitride (SiNx), silicon oxide (SiOx), or silicon oxynitride (SiON).

The passivation layer 114 may be omitted.

An overcoat layer 115 may be provided on the passivation layer 114. The overcoat layer 115 may be disposed substantially all over the substrate 110. The overcoat layer 115 may eliminate a step difference due to the layers thereunder and may have a substantially flat top surface. The overcoat layer 115 may be formed of an organic insulating material such as photosensitive acrylic polymer (photo acryl).

A first connection electrode 132, first and second assembly lines 134 and 136, and first and second assembly electrodes 135 and 137 may be provided on the overcoat layer 115.

The first connection electrode 132, the first and second assembly lines 134 and 136, and the first and second assembly electrodes 135 and 137 may be formed of a metal having relatively high reflectance. For example, the first connection electrode 132, the first and second assembly lines 134 and 136, and the first and second assembly electrodes 135 and 137 may be formed of one or more of: aluminum (Al), copper (Cu), molybdenum (Mo), titanium (Ti), chromium (Cr), nickel (Ni), tungsten (W), and an alloy thereof.

The first connection electrode 132 may overlap the thin film transistor TR and electrically connected to the thin film transistor TR. Specifically, the first connection electrode 132 may be in contact with and electrically connected to the drain electrode 125 through a contact hole provided in the passivation layer 114 and the overcoat layer 115.

The first and second assembly lines 134 and 136 and the first and second assembly electrodes 135 and 137 may be spaced apart from the thin film transistor TR.

The first and second assembly electrodes 135 and 137 may be connected to the first and second assembly lines 134 and 136, respectively. Each of the first and second assembly electrodes 135 and 137 may include a first electrode portion 135a and 137a and a second electrode portion 135b and 137b, and the first electrode portion 135a and 137a may have an opening 135c and 137c.

A first assembly insulation layer 116 may be provided on the first connection electrode 132, the first and second assembly lines 134 and 136, and the first and second assembly electrodes 135 and 137. The first assembly insulation layer 116 may be disposed substantially all over the substrate 110. The first assembly insulation layer 116 may be in contact with the overcoat layer 115 through the opening 135c and 137c.

The first assembly insulation layer 116 may be formed as a single layer or multiple layers of an inorganic insulating material. The inorganic insulating material of the first assembly insulation layer 116 may include silicon nitride (SiNx), silicon oxide (SiOx), or silicon oxynitride (SiON). However, embodiments of the present disclosure are not limited thereto. In other embodiments, the first assembly insulation layer 116 may be omitted.

A second assembly insulation layer 117 may be provided on the first assembly insulation layer 116. The second assembly insulation layer 117 may be disposed substantially all over the substrate 110.

The second assembly insulation layer 117 may cover the first and second assembly lines 134 and 136 and may have an assembly hole 117h corresponding to parts of the first and second assembly electrodes 135 and 137. Specifically, the second assembly insulation layer 117 may cover the first and second assembly lines 134 and 136 and the second electrode portions 135b and 137b of the first and second assembly electrodes 135 and 137 and have the assembly hole 117h corresponding to the first electrode portions 135a and 137a of the first and second assembly electrodes 135 and 137. The first assembly insulation layer 116 may be partially exposed through the assembly hole 117h.

The light-emitting element 140 and an adhesive layer 118 may be provided on the first assembly insulation layer 116 in the assembly hole 117h. The adhesive layer 118 and the second assembly insulation layer 117 may partially surround a side surface of the light-emitting element 140. A height of the adhesive layer 118 and the second assembly insulation layer 117 may be lower than a height of the light-emitting element 140, and the adhesive layer 118 and the second assembly insulation layer 117 may expose a first element electrode 141 and a second element electrode 142 of the light-emitting element 140.

The adhesive layer 118 may be formed after self-assembling the light-emitting element 140 in the assembly hole 117h and may fix the self-assembled light-emitting element 140. The adhesive layer 118 may be formed of a photocurable adhesive material that is cured by light. For example, the adhesive layer 118 may be formed of photosensitive acrylic polymer (photo acryl), but embodiments of the present disclosure are not limited thereto. Alternatively, the adhesive layer 118 may be formed of one of a polyimide (PI) resin, an epoxy resin, a urethane resin, and a polydimethylsiloxane (PDMS) resin.

The light-emitting element 140 may overlap the first electrode portions 135a and 137a of the first and second assembly electrodes 135 and 137 and may be spaced apart from the second electrode portions 135b and 137b of the first and second assembly electrodes 135 and 137.

The light-emitting element 140 may be provided in the form of a micro light-emitting diode chip (micro LED chip or µLED chip) including an n-electrode, an n-type layer, an active layer, a p-type layer, and a p-electrode. The light-emitting element 140 may have a lateral structure in which the n-electrode and the p-electrode are provided on the same side (for example, a second side opposite to a first side facing the substrate 110) and light is emitted through the second side provided with the n-electrode and the p-electrode (for example, the second side opposite to the first side facing the substrate 110).

However, embodiments of the present disclosure are not limited thereto. In other embodiments, the light-emitting element 140 may have a flip-chip structure in which the n-electrode and the p-electrode are provided on the same side (for example, the first side facing the substrate 110) and light is emitted through the second side opposite to the first side provided with the n-electrode and the p-electrode. Alternatively, the light-emitting element 140 may have a vertical structure in which the n-electrode and the p-electrode are provided on opposite sides (for example, a first side facing the substrate 110 and a second side opposite to the first side), respectively.

The light-emitting element 140 may include the first element electrode 141, the second element electrode 142, a light-emitting structure, and a protection layer 146.

The first element electrode 141 and the second element electrode 142 may be provided on the light-emitting structure and may be spaced from each other. The first element electrode 141 and the second element electrode 142 may be disposed at different heights. For example, the second element electrode 142 may be disposed higher than the first element electrode 141.

Here, the first element electrode 141 may be an n-electrode, and the second element electrode 142 may be a p-electrode. The first element electrode 141 may be a cathode, and the second element electrode 142 may be an anode.

However, embodiments of the present disclosure are not limited thereto. Alternatively, in other embodiments, the first element electrode 141 may be a p-electrode, and the second element electrode 142 may be an n-electrode. In this case, the first element electrode 141 may be an anode, and the second element electrode 142 may be a cathode.

The first element electrode 141 and the second element electrode 142 may be formed of a conductive material. For example, the first element electrode 141 and the second element electrode 142 may be formed of a transparent conductive material such as indium tin oxide (ITO) or indium zinc oxide (IZO) or an opaque conductive material such as titanium (Ti), gold (Au), silver (Ag), copper (Cu), or an alloy thereof. However, embodiments of the present disclosure are not limited thereto.

The light-emitting structure may include a first semiconductor layer 143, a light-emitting layer 144, and a second semiconductor layer 145. The light-emitting layer 144 may be disposed between the first semiconductor layer 143 and the second semiconductor layer 145.

The light-emitting layer 144 and the second semiconductor layer 145 may correspond to a part of the first semiconductor layer 143 and may be disposed on the first semiconductor layer 143. The light-emitting layer 144 and the second semiconductor layer 145 may have a smaller width and area than the first semiconductor layer 143 to partially expose a top surface of the first semiconductor layer 143. The first element electrode 141 may be disposed on the exposed top surface of the first semiconductor layer 143, and the second element electrode 142 may be disposed on the second semiconductor layer 145.

The first semiconductor layer 143 and the second semiconductor layer 145 may be formed by doping n-type or p-type impurities into a semiconductor material. For example, the first semiconductor layer 143 and the second semiconductor layer 145 may be formed by doping n-type or p-type impurities into gallium nitride (GaN), indium aluminum phosphide (InAlP), or gallium arsenide (GaAs). In addition, for example, the n-type impurities may be silicon (Si), germanium (Ge), or tin (Sn), and the p-type impurities may be magnesium (Mg), zinc (Zn), or beryllium (Be). However, embodiments of the present disclosure are not limited thereto.

The light-emitting layer 144 may receive electrons and holes from the first semiconductor layer 143 and the second semiconductor layer 145, respectively, and emit light. The light-emitting layer 144 may be formed of a single quantum well (SQW) structure or a multi quantum well (MQW) structure. For example, the light-emitting layer 144 may be formed of indium gallium nitride (InGaN) or gallium nitride (GaN), but is not limited thereto.

A protection layer 146 may be provided on the light-emitting structure provided with the first element electrode 141 and the second element electrode 142 thereon. The protection layer 146 may cover the first element electrode 141, the second element electrode 142, and the light-emitting structure and may partially expose top surfaces of the first element electrode 141 and the second element electrode 142.

The protection layer 146 may be formed as a single layer or multiple layers of an inorganic insulating material. The inorganic insulating material of the protection layer 146 may include silicon nitride (SiNx), silicon oxide (SiOx), or silicon oxynitride (SiON).

A first pixel electrode 152 and a second connection electrode 154 may be provided on the second assembly insulation layer 117 provided with the light-emitting element 140 and the adhesive layer 118 in the assembly hole 117h.

The first pixel electrode 152 may overlap the light-emitting element 140. The first pixel electrode 152 may be in contact with and electrically connected to the first element electrode 141 of the light-emitting element 140 and may be spaced apart from the second element electrode 142 of the light-emitting element 140. The first pixel electrode 152 may have an open portion corresponding to and exposing the second element electrode 142.

In addition, the first pixel electrode 152 may overlap the first and second assembly lines 134 and 136 and may be in contact with and electrically connected to the first and second assembly lines 134 and 136 through contact holes provided in the second assembly insulation layer 117 and the first assembly insulation layer 116.

Accordingly, the first element electrode 141 of the light-emitting element 140 may be electrically connected to the first and second assembly lines 134 and 136 through the first pixel electrode 152. In this case, the first and second assembly lines 134 and 136 may transmit a low potential voltage VSS to the first element electrode 141 of the light-emitting element 140.

The first pixel electrode 152 may also overlap the adhesive layer 118 and the second assembly insulation layer 117.

The second connection electrode 154 may overlap the first connection electrode 132. The second connection electrode 154 may be in contact with and electrically connected to the first connection electrode 132 through a contact hole provided in the second assembly insulation layer 117 and the first assembly insulation layer 116. Accordingly, the second connection electrode 154 may electrically connected to the drain electrode 125 of the thin film transistor TR through the first connection electrode 132.

The first pixel electrode 152 and the second connection electrode 154 may be formed of a transparent conductive material such as indium tin oxide (ITO) or indium zinc oxide (IZO). Alternatively, the first pixel electrode 152 and the second connection electrode 154 may be formed of a conductive material such as metal. For example, the first pixel electrode 152 and the second connection electrode 154 may be formed of one or more of: aluminum (Al), copper (Cu), molybdenum (Mo), titanium (Ti), chromium (Cr), nickel (Ni), tungsten (W), and an alloy thereof.

A planarization layer 119 may be provided on the first pixel electrode 152 and the second connection electrode 154. The planarization layer 119 may be disposed substantially all over the substrate 110.

The planarization layer 119 may partially surround the side surface of the light-emitting element 140. The planarization layer 119 may flatten a top surface of the substrate 110 provided with the light-emitting element 140 thereon together with the second assembly insulation layer 117 and may fix and protect the light-emitting element 140 together with the adhesive layer 118 and the second assembly insulation layer 117.

The planarization layer 119 may cover the light-emitting element 140 and the first pixel electrode 152 and partially expose the light-emitting element 140. Specifically, planarization layer 119 may cover the first element electrode 141 of the light-emitting element 140 and the first pixel electrode 152 and may expose a part of the second element electrode 142 of the light-emitting element 140.

In addition, the planarization layer 119 may expose the second connection electrode 154 without covering it. Alternatively, the planarization layer 119 may partially expose the second connection electrode 154.

The planarization layer 119 may be formed of an organic insulating material such as photosensitive acrylic polymer (photo acryl).

Next, a second pixel electrode 162 may be provided on the planarization layer 119. The second pixel electrode 162 may overlap the light-emitting element 140, the first pixel electrode 152, and the second connection electrode 154.

Specifically, the second pixel electrode 162 may overlap the first and second element electrodes 141 and 142 of the light-emitting element 140 and may be in contact with and electrically connected to the exposed part of the second element electrode 142. In addition, the second pixel electrode 162 may overlap the first pixel electrode 152, and thus may also overlap the first and second assembly lines 134 and 136.

The second pixel electrode 162 may extend to cover and overlap the second connection electrode 154 and may be in contact with and electrically connected to the second connection electrode 154. Accordingly, the second pixel electrode 162 may be electrically connected to the first connection electrode 132 through the second connection electrode 154. The second element electrode 142 of the light-emitting element 140 may be electrically connected to the drain electrode 125 of the thin film transistor TR through the second pixel electrode 162 and the first and second connection electrodes 132 and 154, and may be electrically connected to the data line DL of FIG. 5.

The second pixel electrode 162 may be formed of a transparent conductive material such as indium tin oxide (ITO) or indium zinc oxide (IZO). Alternatively, the second pixel electrode 162 may be formed of a conductive material such as metal. For example, the second pixel electrode 162 may be formed of one or more of: aluminum (Al), copper (Cu), molybdenum (Mo), titanium (Ti), chromium (Cr), nickel (Ni), tungsten (W), and an alloy thereof.

As such, in the display device according to the embodiment of the present disclosure, by providing the first and second assembly lines 134 and 136 and the first and second assembly electrodes 135 and 137 for transferring the light-emitting element 140 on the substrate 110 provided with the thin film transistor TR thereon, the number of transfer steps can be reduced. Accordingly, the manufacturing process can be shortened and manufacturing costs can be reduced. In addition, the transfer defects can be prevented or minimized.

Further, since the first and second assembly lines 134 and 136 and the first and second assembly electrodes 135 and 137 can be used as a power line, the degree of freedom in design can be increased.

Meanwhile, the first and second assembly electrodes 135 and 137 may have a double-layered structure, and such a display device according to another embodiment of the present disclosure will be described with reference to FIGS. 7 to 10.

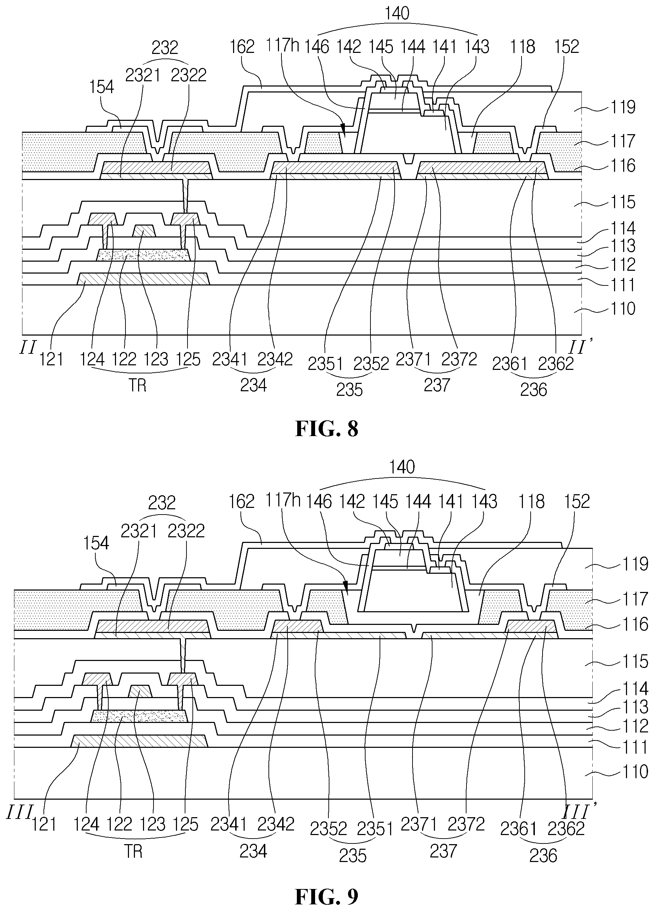

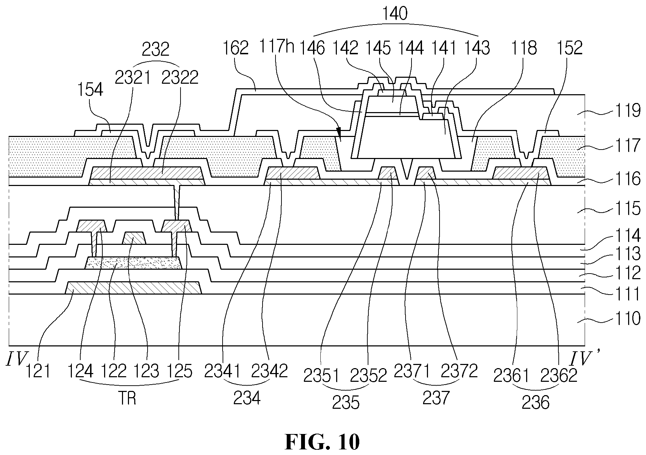

FIG. 7 is a schematic plan view of a display device according to another embodiment of the present disclosure, and FIG.S 8 to 10 are schematic cross-sectional views of the display device according to another embodiment of the present disclosure. FIG. 8 shows a cross-section corresponding to line II-II' of FIG. 7, FIG. 9 shows a cross-section corresponding to line III-III' of FIG. 7, and FIG. 10 shows a cross-section corresponding to line IV-IV' of FIG. 7.

The display device according to another embodiment of the present disclosure has substantially the same configuration as that of the previous embodiment, except for the connection electrode, the assembly line, and the assembly electrode. The same parts as those of the previous embodiment are designated by the same or similar reference signs, and explanation for the same parts may be shortened or omitted.

In FIGS. 7 to 10, each of first and second assembly lines 234 and 236 and first and second assembly electrodes 235 and 237 may have a double-layered structure including a lower layer and an upper layer. The lower layer may be formed of a conductive material having higher specific resistance (or resistivity) than that of the upper layer.

In this case, a first connection electrode 23 may also have a double-layered structure including a lower layer and an upper layer. However, embodiments of the present disclosure are not limited thereto. In other embodiments, the first connection electrode may have a single-layered structure.

Specifically, the first assembly line 234 may include a first lower assembly line 2341 and a first upper assembly line 2342, and the second assembly line 236 may include a second lower assembly line 2361 and a second upper assembly line 2362. The first assembly electrode 235 may include a first lower assembly electrode 2351 and a first upper assembly electrode 2352, and the second assembly electrode 237 may include a second lower assembly electrode 2371 and a second upper assembly electrode 2372. In addition, the first connection electrode 232 may include a first lower connection electrode 2321 and a first upper connection electrode 2322.

Here, the first and second lower assembly lines 2341 and 2361, the first and second lower assembly electrodes 2351 and 2371, and the first lower connection electrode 2321 may be formed of a conductive material having higher resistivity than the first and second upper assembly lines 2342 and 2362, the first and second upper assembly electrodes 2352 and 2372, and the first upper connection electrode 2322. Accordingly, the first and second lower assembly lines 2341 and 2361, the first and second lower assembly electrodes 2351 and 2371, and the first lower connection electrode 2321 may have higher resistance than the first and second upper assembly lines 2342 and 2362, the first and second upper assembly electrodes 2352 and 2372, and the first upper connection electrode 2322.

For example, the first and second lower assembly lines 2341 and 2361, the first and second lower assembly electrodes 2351 and 2371, and the first lower connection electrode 2321 may be formed of a transparent conductive material such as indium tin oxide (ITO) or indium zinc oxide (IZO). The first and second upper assembly lines 2342 and 2362, the first and second upper assembly electrodes 2352 and 2372, and the first upper connection electrode 2322 may be formed of a conductive material such as aluminum (Al), copper (Cu), molybdenum (Mo), titanium (Ti), chromium (Cr), nickel (Ni), tungsten (W), and an alloy thereof.

Meanwhile, the first and second lower assembly electrodes 2351 and 2371 may have a larger area than the first and second upper assembly electrodes 2352 and 2372. For example, the first and second lower assembly electrodes 2351 and 2371 may have a rectangular shape, and the first and second upper assembly electrodes 2352 and 2372 may have the same configuration as the first and second assembly electrodes 135 and 137 of FIG. 3, i.e., the configuration including the T-like shape. However, embodiments of the present disclosure are not limited thereto. In other embodiments, the first and second upper assembly electrodes 2352 and 2372 may have the same configuration as the first and second assembly electrodes 135 and 137 of FIG. 1 or FIG. 4. The first and second lower assembly electrodes 2351 and 2371 and the first and second upper assembly electrodes 2352 and 2372 may partially overlap the light-emitting element 140.

As described above, the length of the first side S1 of the first and second upper assembly electrodes 2352 and 2372, which overlaps the light-emitting element 140, may be smaller than diameters of the light-emitting element 140 and the assembly hole 117h. The length of the second side S2 of the first and second upper assembly electrodes 2352 and 2372, which is spaced apart from the light-emitting element 140, may be greater than the diameters of the light-emitting element 140 and the assembly hole 117h. The first side S1 may be disposed within a boundary of the light-emitting element 140 and may not be exposed outside the boundary of the light-emitting element 140.

On the other hand, a length of a third side S3 of the first and second lower assembly electrodes 2351 and 2371, which overlaps the light-emitting element 140, may be greater than the length of the first side S1 and may be equal to the length of the second side S2.

In this case, the length of the third side S3 of the first and second lower assembly electrodes 2351 and 2371 may be greater than the diameters of the light-emitting element 140 and the assembly hole 117h. In the assembly hole 117h, the third side S3 may be exposed outside the boundary of the light-emitting element 140. On the other hand, the length of the first side S1 of the first and second upper assembly electrodes 2352 and 2372 may be smaller than the diameters of the light-emitting element 140 and the assembly hole 117h. In the assembly hole 117h, the first side S1 may not be exposed outside the boundary of the light-emitting element 140.

As such, in the display device according to another embodiment of the present disclosure, the first and second assembly electrodes 235 and 237 may be configured to have the double-layered structure including the lower layer and the upper layer with different resistivity and areas. Accordingly, by increasing the area where the electric field is generated within the assembly hole 117h to generate a relatively strong electric field, self-assembly of the light-emitting element 140 can be facilitated.

In addition, even if the first and second assembly electrodes 235 and 237 are exposed within the assembly hole 117h after self-assembly of the light-emitting element 140, since the first and second lower assembly electrodes 2351 and 2371 formed of a material with relatively low resistivity are exposed and the intensity of the electric field is relatively weak, it is possible to prevent a defect in which another light-emitting element is double-assembled within the assembly hole 117h in which the light-emitting element 140 is assembled.

The display device of the present disclosure can prevent a defect in which the light-emitting element is double-assembled by preventing two adjacent sides of the assembly electrodes that generates the electric field from being exposed to outside the boundary of the self-assembled light-emitting element.

In addition, by providing the opening to minimize the contact area between the assembly electrodes and the light-emitting element, it is possible to prevent a defect in which the light-emitting element is damaged during the transfer process.

In addition, by providing the assembly electrodes on the substrate of the display device, the number of transfer steps can be reduced, so that the manufacturing process can be shortened and manufacturing costs can be reduced. Since the assembly electrodes and the assembly lines are used as a power line, the degree of freedom in design can be increased. Accordingly, the manufacturing process of the display device can be optimized and the production energy can be reduced.

Further, by forming the assembly electrodes as a double-layered structure with different resistivity and areas, the self-assembly of the light-emitting element can be facilitated, and a defect in which the light-emitting element is double-assembled can be prevented.

The following examples pertain to further embodiments of the present disclosure:
Example 1: A self-assembly substrate, comprising; a first assembly line and a second assembly line spaced apart from each other in a first direction and extending in a second direction crossing the first direction; an insulation layer on the first assembly line and the second assembly line, the insulation layer including an assembly hole between the first assembly line and the second assembly line; a first assembly electrode between the first assembly line and the assembly hole; and a second assembly electrode between the second assembly line and the assembly hole, wherein the first and second assembly electrodes respectively include a first side exposed by the assembly hole and a second side connected to the first and second assembly lines, and wherein each end of the first side is located within the assembly hole and spaced apart from an edge of the assembly hole.
Example 2: The self-assembly substrate of Example 1, wherein a length of the first side in the second direction is smaller than a length of the second side in the second direction.
Example 3: The self-assembly substrate of Example 1 or 2, wherein each of the first and second assembly electrodes includes an opening overlapping the assembly hole.
Example 4: The self-assembly substrate of any of Examples 1 to 3, wherein a portion of each of the first and second assembly electrodes exposed by the assembly hole has a trapezoidal shape, an L-like shape or a T-like shape.
Example 5: The self-assembly substrate of any of Examples 1 to 4, wherein a length of the first side exposed by the assembly hole in the second direction is greater than a length of a remaining part of each of the first and second assembly electrodes exposed by the assembly hole in the second direction.
Example 6: The self-assembly substrate of any of Examples 1 to 5, further comprising: a first lower assembly electrode below the first assembly electrode; and a second lower assembly electrode below the second assembly electrode, wherein a resistivity of each of the first and second lower assembly electrodes is greater than a resistivity of each of the first and second assembly electrodes.
Example 7: The self-assembly substrate of Example 6, wherein an area of each of the first and second lower assembly electrodes exposed by the assembly hole is greater than an area of each of the first and second assembly electrodes exposed by the assembly hole.
Example 8: The self-assembly substrate of Example 7, wherein the first and second lower assembly electrodes respectively include a third side corresponding to the first side, and wherein a length of the first side in the second direction is smaller than a length of the third side in the second direction.
Example 9: The self-assembly substrate of any of Examples 1 to 8, wherein a plurality of assembly holes are provided between the first assembly line and the second assembly line, and wherein the plurality of assembly holes have different sizes or shapes according to a color of a light-emitting element to be self-assembled in a corresponding assembly hole.
Example 10: The self-assembly substrate of any of Examples 1 to 9, wherein the self-assembly substrate is an active-matrix substrate having a plurality of thin film transistor disposed thereon.
Example 11: A display device, comprising: a substrate; a first assembly line and a second assembly line on the substrate, the first and second assembly lines spaced apart from each other in a first direction and extending in a second direction crossing the first direction; a first assembly electrode and a second assembly electrode between the first assembly line and the second assembly line and spaced apart from each other in the first direction; and a light-emitting element on the first assembly electrode and the second assembly electrode, wherein the first and second assembly electrodes respectively include a first side covered by the light-emitting element and a second side connected the first and second assembly lines, and wherein the first side is located within a boundary of the light-emitting element.
Example 12: The display device of Example 11, further comprising: an insulation layer having an assembly hole exposing the first and second assembly electrodes, wherein the light-emitting element is in the assembly hole.
Example 13: The display device of Example 11 or 12, wherein a length of the first side in the second direction is smaller than a length of the second side in the second direction.
Example 14: The display device of any of Examples 11 to 13, wherein each of the first and second assembly electrodes includes an opening overlapping the light-emitting element.
Example 15: The display device of any of Examples 11 to 14, wherein a length of the first side covered by the light-emitting element in the second direction is greater than a length of a remaining part of each of the first and second assembly electrodes covered by the light-emitting element in the second direction.
Example 16: The display device of any of Examples 1 1 to 15, further comprising: a first lower assembly electrode below the first assembly electrode; and a second lower assembly electrode below the second assembly electrode, wherein a resistivity of each of the first and second lower assembly electrodes is greater than a resistivity of each of the first and second assembly electrodes.
Example 17: The display device of any of Example 16, wherein an area of each of the first and second lower assembly electrodes covered by the light-emitting element is greater than an area of each of the first and second assembly electrodes covered by the light-emitting element.
Example 18: The display device of Example 17, wherein the first and second lower assembly electrodes respectively include a third side corresponding to the first side, and wherein a length of the first side in the second direction is smaller than a length of the third side in the second direction.
Example 19: The display device of any of Examples 11 to 18, wherein the light-emitting element includes red, green, and blue light-emitting elements arranged in the second direction, wherein the red, green, and blue light-emitting elements have different sizes or shapes.
Example 20; The display device of any of Examples 11 to 19, wherein a portion of each of the first and second assembly electrodes covered by the light-emitting element has a trapezoidal shape, an L-like shape or a T-like shape.
Example 21: A display device, comprising: the assembly substrate of any of Examples 1 to 10; and a light-emitting element in the assembly hole and on the first assembly electrode and the second assembly electrode, wherein the first side is covered by the light-emitting element, and wherein the first side is located within a boundary of the light-emitting element.
Example 22: The display device of Example 21, wherein the light-emitting element includes red, green, and blue light-emitting elements arranged in the second direction, wherein the red, green, and blue light-emitting elements have different sizes or shapes.
Example 23: The display device of Example 21 or 22 referring, directly or indirectly, back to Example 3, wherein the opening of each of the first and second assembly electrodes overlaps the light-emitting element.
Example 24: The display device of any of Examples 21 to 23, wherein a length of the first side covered by the light-emitting element in the second direction is greater than a length of a remaining part of each of the first and second assembly electrodes covered by the light-emitting element in the second direction.
Example 25: The display device of any of Examples 21 to 24 referring, directly or indirectly, back to Example 6, wherein an area of each of the first and second lower assembly electrodes covered by the light-emitting element is greater than an area of each of the first and second assembly electrodes covered by the light-emitting element.
Example 26: The display device of any of Examples 21 to 25, wherein a portion of each of the first and second assembly electrodes covered by the light-emitting element has a trapezoidal shape, an L-like shape or a T-like shape

## Claims

1. A self-assembly substrate, comprising;
a first assembly line (134) and a second assembly line (136) spaced apart from each other in a first direction (X) and extending in a second direction (Y) crossing the first direction (X);
an insulation layer (117) on the first assembly line (134) and the second assembly line (136), the insulation layer (117) including an assembly hole (117h) between the first assembly line (134) and the second assembly line (136);
a first assembly electrode (135) between the first assembly line (134) and the assembly hole (117h); and
a second assembly electrode (137) between the second assembly line (136) and the assembly hole (117h),
wherein the first and second assembly electrodes (135, 137) respectively include a first side (S1) exposed by the assembly hole (117h) and a second side (S2) connected to the first and second assembly lines (134, 136), and
wherein each end of the first side (S1) is located within the assembly hole (117h) and spaced apart from an edge of the assembly hole (117h).

2. The self-assembly substrate of claim 1, wherein a length of the first side (S1) in the second direction (Y) is smaller than a length of the second side (S2) in the second direction (Y).

3. The self-assembly substrate of claim 1 or 2, wherein each of the first and second assembly electrodes (135, 137) includes an opening (135c, 137c) overlapping the assembly hole (117h).

4. The self-assembly substrate of any of claims 1 to 3, wherein a portion of each of the first and second assembly electrodes (135, 137) exposed by the assembly hole (117h) has a trapezoidal shape, an L-like shape or a T-like shape.

5. The self-assembly substrate of any of claims 1 to 4, wherein a length of the first side (S1) exposed by the assembly hole (117h) in the second direction (Y) is greater than a length of a remaining part of each of the first and second assembly electrodes (135, 137) exposed by the assembly hole (117h) in the second direction (Y).

6. The self-assembly substrate of any of claims 1 to 5, further comprising:
a first lower assembly electrode (2351) below the first assembly electrode (135); and
a second lower assembly electrode (2371) below the second assembly electrode (137),
wherein a resistivity of each of the first and second lower assembly electrodes (2351, 2371) is greater than a resistivity of each of the first and second assembly electrodes (135, 137).

7. The self-assembly substrate of claim 6, wherein an area of each of the first and second lower assembly electrodes (2351, 2371) exposed by the assembly hole (117h) is greater than an area of each of the first and second assembly electrodes (135, 137) exposed by the assembly hole (117h).

8. The self-assembly substrate of claim 7, wherein the first and second lower assembly electrodes (2351, 2371) respectively include a third side (S3) corresponding to the first side (S1), and
wherein a length of the first side (S1) in the second direction (Y) is smaller than a length of the third side (S3) in the second direction (Y).

9. The self-assembly substrate of any of claims 1 to 8, wherein a plurality of assembly holes (117h) are provided between the first assembly line (134) and the second assembly line (136), and
wherein the plurality of assembly holes (117h) have different sizes or shapes according to a color of a light-emitting element (140) to be self-assembled in a corresponding assembly hole (117h).

10. The self-assembly substrate of any of claims 1 to 9, wherein the self-assembly substrate is an active-matrix substrate having a plurality of thin film transistors (TR) disposed thereon.

11. A display device, comprising:
the assembly substrate of any of claims 1 to 10; and
a light-emitting element (140) in the assembly hole (117h) and on the first assembly electrode (135) and the second assembly electrode (137),
wherein the first side (S1) is covered by the light-emitting element (140), and
wherein the first side (S1) is located within a boundary of the light-emitting element (140),
wherein, preferably:
the light-emitting element (140) includes red, green, and blue light-emitting elements arranged in the second direction (Y),
wherein the red, green, and blue light-emitting elements have different sizes or shapes.

12. The display device of claim 11 referring, directly or indirectly, back to claim 3, wherein the opening (135c, 137c) of each of the first and second assembly electrodes (135, 137) overlaps the light-emitting element (140).

13. The display device of claim 11 or 12, wherein a length of the first side (S1) covered by the light-emitting element (140) in the second direction (Y) is greater than a length of a remaining part of each of the first and second assembly electrodes (135, 137) covered by the light-emitting element (140) in the second direction (Y).

14. The display device of any of claims 11 to 13 referring, directly or indirectly, back to claim 6, wherein an area of each of the first and second lower assembly electrodes (2351, 2371) covered by the light-emitting element (140) is greater than an area of each of the first and second assembly electrodes (135, 137) covered by the light-emitting element (140).

15. The display device of any of claims 11 to 14, wherein a portion of each of the first and second assembly electrodes (135, 137) covered by the light-emitting element (140) has a trapezoidal shape, an L-like shape or a T-like shape.
